# EUROPÄISCHE PATENTSCHRIFT

(11) **EP 1 714 476 B1**
(45) Veröffentlichungstag und Bekanntmachung des Hinweises auf die Patenterteilung: **11.01.2012**
(21) Anmeldenummer: 04820353.3
(22) Anmeldetag: 22.11.2004
(51) Int. Cl.: H04N 5/225

(54) **OPTISCHES MODUL**
OPTICAL MODULE
MODULE OPTIQUE

(30) Priorität: 13.01.2004 DE 102004001698
(43) Veröffentlichungstag der Anmeldung: 25.10.2006
(73) Patentinhaber: ROBERT BOSCH GMBH, 70442 Stuttgart (DE)
(72) Erfinder: APEL, Uwe, 72666 Neckartailfingen (DE); SCHICK, Jens, 71083 Herrenberg (DE)
(86) Internationale Anmeldenummer: PCT/EP2004/053038
(87) Internationale Veröffentlichungsnummer: WO 2005/069602

(56) Entgegenhaltungen:
- DE-A1- 19 651 260
- US-A1- 2003 175 027
- PATENT ABSTRACTS OF JAPAN Bd. 1996, Nr. 07, 31. Juli 1996 (1996-07-31) -& JP 08 084277 A (MITSUBISHI ELECTRIC CORP), 26. März 1996 (1996-03-26)
- PATENT ABSTRACTS OF JAPAN Bd. 2000, Nr. 24, 11. Mai 2001 (2001-05-11) -& JP 2001 197337 A (ICHIKOH IND LTD), 19. Juli 2001 (2001-07-19)
- PATENT ABSTRACTS OF JAPAN Bd. 008, Nr. 091 (E-241), 26. April 1984 (1984-04-26) -& JP 59 010078 A (KONISHIROKU SHASHIN KOGYO KK), 19. Januar 1984 (1984-01-19)
- PATENT ABSTRACTS OF JAPAN Bd. 013, Nr. 453 (E-831), 11. Oktober 1989 (1989-10-11) -& JP 01 175376 A (ECHO:KK; others: 01), 11. Juli 1989 (1989-07-11)
- PATENT ABSTRACTS OF JAPAN Bd. 008, Nr. 021 (E-224), 28. Januar 1984 (1984-01-28) -& JP 58 182966 A (CANON KK), 26. Oktober 1983 (1983-10-26)

## Beschreibung

### Stand der Technik

Die Erfindung betrifft ein optisches Modul mit einem Bildsensor nach dem Oberbegriff des Anspruchs 1. Dieses optische Modul eignet sich bevorzugt für einen mobilen Einsatz unter schwierigen Umgebungsbedingungen, insbesondere für eine Anwendung in Kraftfahrzeugen

Aus der auf die Anmelderin zurückgehenden DE 199 17 438 A1 ist eine Leiterplatte mit einem auf dieser Leiterplatte angeordneten Bildaufnehmer umfassende Schaltungsanordnung bekannt, wobei die Anschlusskontakte des Bildaufnehmers mit entsprechenden Kontakten der Leiterplatte elektrisch leitend verbunden sind. Die Schaltungsanordnung umfasst weiterhin eine Trägerplatte mit Anschlusskontakten, auf der der Bildaufnehmer mit seinen Anschlusskontakten den Anschlusskontakten der Trägerplatte zugewandt und mit diesen elektrisch leitend verbunden angeordnet ist. Die Trägerplatte weist in dem Bereich einer lichtempfindlichen Fläche des Bildaufnehmers eine auf diese angepasste Öffnung auf. Die Trägerplatte ihrerseits ist auf der Leiterplatte unter Ausbildung elektrisch leitender Verbindungen zwischen Kontaktelementen der Trägerplatte und Kontaktelementen der Leiterplatte befestigt.

Aus DE 196 51 260 A1 ist ein Bildsensor-Chip und entsprechendes Trägerelement bekannt. Dabei weist der Bildsensor-Chip auf einer Hauptseite eine optische Sensorfläche und elektrische Kontaktflächen auf und ist in Flip-Chip-Technik mit der Hauptseite nach unten auf dem Trägerelement befestigbar. Im Trägerelement, beispielsweise einer Platine, befindet sich eine Öffnung, durch die Licht auf die Sensorfläche fallen kann. Als Vorteil ergibt sich, dass kein Gehäuse für den Chip notwendig ist und die Montage preisgünstig durchführbar ist. Das Trägerelement kann Teil eines Kameragehäuses sein.

Aus Patent Abstracts of Japan 08-084277 ist eine klein bauende und schwingungsfeste Kamera für den Fahrzeugeinsatz bekannt, die durch eine Kunstharzumhüllung der signalverarbeitenden Komponenten wasserfest ist. Bei der Kamera ist eine Schaltungsplatine mit darauf angeordneter Optik im Wesentlichen vollständig in Kunstharz eingebettet, so dass kein Wasser eindringen kann.

Aus US 2003/0175027 A1 ist eine Befestigungseinrichtung für die Befestigung einer Kamera bekannt. Die Befestigungseinrichtung umfasst einen gelochten Rahmen und einen hohlen Schraubbolzen, der durch den gelochten Rahmen hindurchgreift und mit einer Schraube verschraubbar ist. Ein zu der Kamera führendes Kabel ist durch den Schraubbolzen hindurchgeführt.

Aus JP 2001197337 A ist eine Kamera für Fahrzeuganwendungen bekannt, die vor Feuchtigkeit und Verschmutzung geschützt ist. Bis auf den freiliegenden Sensor ist die Kamera vollständig von einem schützenden Gehäuse umgeben. Aus JP 59010078 A ist eine Fernsehkamera mit einer Schutzeinrichtung für die Unterdrückung elektromagnetischer Störungen bekannt. Die Schutzeinrichtung besteht aus einem netzartigen Geflecht aus leitendem Material, das in Kunstharz eingebettet ist und störanfällige Komponenten der Fernsehkamera im Wesentlichen rohrförmig umgibt.

Aus Patent Abstracts of Japan 01-175376 ist eine Videokamera mit einer preisgünstigen Abschirmungseinrichtung gegen elektrostatische Störeinflüsse bekannt. Die Abschirmungseinrichtung besteht aus einer im Wesentlichen zylindrischen Halterung für einen Halbleitersensor. Die aus Kunststoff bestehende Halterung enthält eine leitfähige Substanz, wie beispielsweise Kohlenstoff.

Aus Patent Abstracts of Japan 58-182966 ist eine gegen Störeinflüsse abgeschirmte Videokamera bekannt. Die Abschirmwirkung wird durch ein Gehäuse erreicht, das aus Kunststoff mit eingelagerten Partikeln au8s elektrisch gut leitendem Material wie beispielsweise Aluminium oder Nickel besteht.

### Vorteile der Erfindung

Ziel der vorliegenden Erfindung ist es, die aus dem Stand der Technik bekannte Schaltungsanordnung weiter zu verbessern. Durch die Erfindung gemäß Anspruch 1 wird ein kompaktes optisches Modul geschaffen, das auch unter extremen Umweltbedingungen betriebssicher funktioniert. Der Bildaufnehmer ist auf einer Trägerplatte angeordnet, die weiterhin alle Komponenten trägt, die in ihrer Gesamtheit die Funktionalität des optischen Moduls darstellen. Daraus ergibt sich der Vorteil, dass der der Bildaufnehmer zum Einbau eines Objektivs in Betrieb genommen werden kann, um so über eine Bildauswertung der von dem optischen Modul gelieferten Bilder, beispielsweise eines Testbilds, eine optimale Fokussierung zu gewährleisten. Das optische Modul ist besonders schockresistent, sicher gegen EMV-Störungen, unempfindlich gegen Feuchtigkeit und thermisch stabil. Es eignet sich daher besonders für eine mobile Anwendung, insbesondere für den Einsatz in Kraftfahrzeugen. Durch den einfachen Aufbau ist nur eine vergleichsweise geringe Anzahl von Montageschritten erforderlich. Dadurch lässt sich auch in der Großserienproduktion eine hohe Fertigungspräzision bei geringen Fertigungskosten erreichen. Das Modul ermöglicht weiterhin eine verbesserte Lagegenauigkeit in dem Einbauzustand, da eine direkte Kopplung des optischen Moduls mit einer Trägereinrichtung eines Fahrzeugs vorgesehen ist. Dadurch entfallen aufwendige Justierarbeiten bei der Montage in einem Fahrzeug. Das optische Modul kann fertigungsgünstig mit einem hermetisch dichten Hinterlinsenraum ausgestattet werden, um schädliche Umwelteinflüsse auf die empfindlichen optischen Komponenten des Moduls zu verhindern. Alternativ sind Trocknungsmittel einfach integrierbar. Weiterhin bietet das Modul die Möglichkeit, eine Streulichtblende direkt anzugießen. Eine weitere Vereinfachung lässt durch Weglassen einer Hülse für die Aufnahme der optischen Komponenten erzielen. Diese werden mittels eines angegossenen Gewindes befestigt oder ohne Gewinde unmittelbar mit dem Modul verklebt. Anstelle eines aufwändig zu montierenden Steckers kann das Endstück eines das Modul mit anderen Baugruppen verbindenden Kabels direkt mit dem Modul vergossen werden.

### Zeichnung

Beispiele eines optischen moduls werden nachfolgend unter Bezug auf die Zeichnung näher erläutert. Dabei zeigt
Figur 1 eine Aufsicht auf ein optisches Modul,
Figur 2 einen Schnitt entlang der Linie A-A' von Figur 1,
Figur 3 eine Aufsicht auf ein weiteres optisches Modul,
Figur 4 einen Schnitt entlang der Linie A-A' von Figur 3,
Figur 5 eine Aufsicht auf ein weiteres optisches Modul
Figur 6 einen Schnitt entlang der Linie A-A' von Figur 5,
Figur 7 eine Aufsicht auf ein weiteres optisches Modul,
Figur 8 einen Schnitt entlang der Linie A-A' von Figur 7,
Figur 9 eine Schnittdarstellung einer weiteren Ausführungsvariante eines optischen Moduls, und
Figur 10 eine Schnittdarstellung einer weiteren Ausführungsvariante eines optischen Moduls.

### Beschreibung der Ausführungsbeispiele

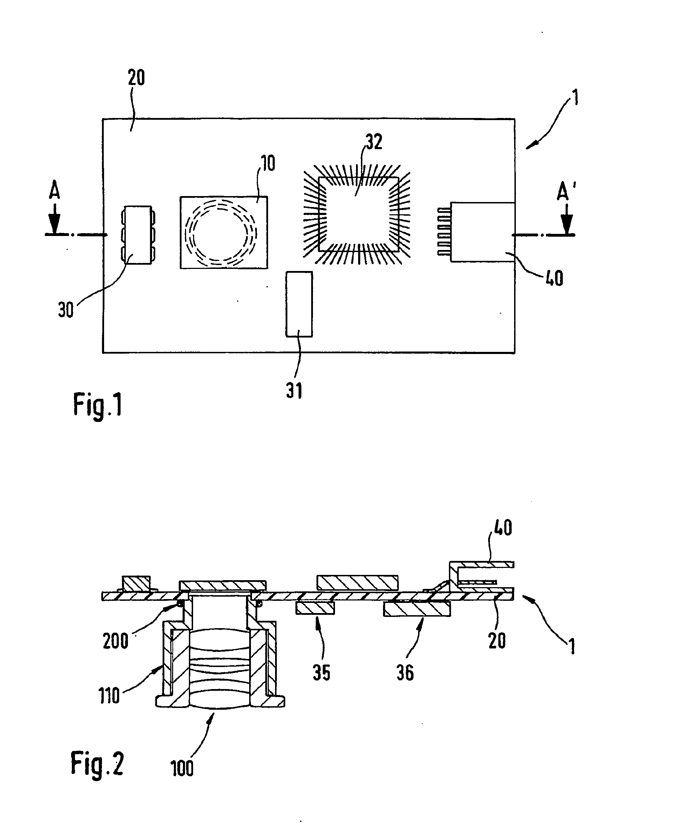

Ausführungsbeispiele der Erfindung und die Schritte für die Herstellung optischer Module werden nachfolgend unter Bezug auf die Zeichnung näher erläutert. Dabei zeigt Figur 1 eine Aufsicht auf ein optisches Modul 1 und Figur 2 eine Schnittdarstellung des optischen Moduls 1 gemäß Figur 1 entlang einer Linie A-A' von Figur 1. Das optische Modul 1 umfasst eine Trägerplatte 20, die beidseitig optische und elektronische Bauelemente trägt. Mit Bezugsziffer 10 ist ein auf der Trägerplatte 20 montierter Bildsensor bezeichnet, der vorzugsweise in Flip-Chip-Technik mit der Trägerplatte 20 verbunden ist. Diese Montageart ist beispielsweise in der eingangs zum Stand der Technik zitierten DE 199 17 438 A1 beschrieben. Mit Bezugsziffern 30,31,32,333,34,35 36 sind weitere auf beiden Seiten der Trägerplatte 20 angeordnete aktive und passive elektronische Bauelemente bezeichnet, die zusammen mit dem Bildsensor 10 einen Bildaufnehmer bilden. Ebenfalls mit der Trägerplatte 20 verbunden ist eine Hülse 110, die ein optisches Objektiv 100 aufnimmt, das in der Hülse 110 verschiebbar gelagert ist. Die Hülse 110 ist zusätzlich mit einer Dichtung 200 gegen die Trägerplatte 20 abgedichtet. Die Dichtung 200 verhindert das Eindringen von Feuchtigkeit und Verunreinigungen in das Innere des optischen Moduls 1.

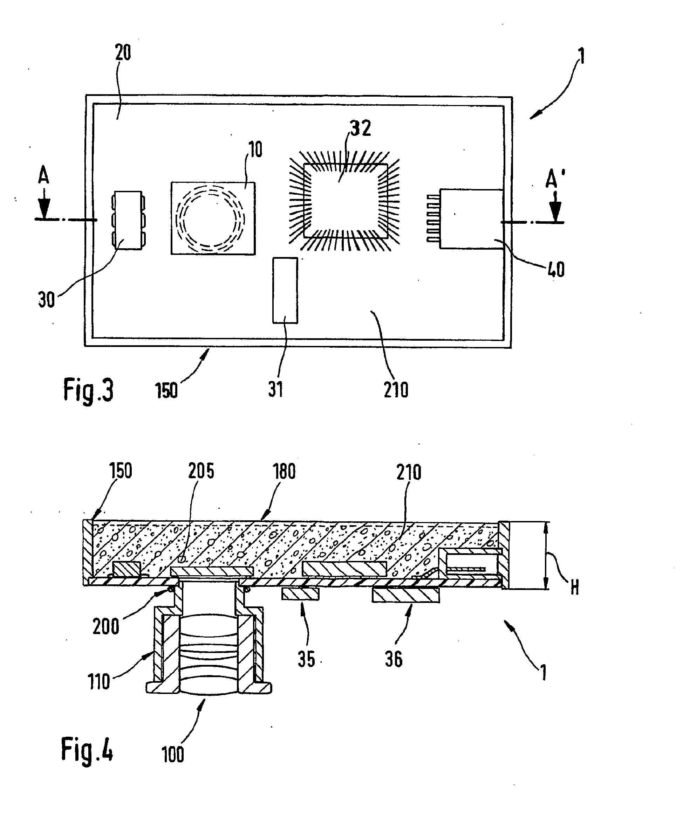

Figur 3 zeigt eine Aufsicht auf ein beispiel eines optischen Moduls 1 und Figur 4 zeigt einen Schnitt durch dieses Modul entlang der Linie A-A' von Figur 3. Bei diesem Ausführungsbeispiel ist ein die Trägerplatte 20 allseitig umfassender Rahmen 150 vorgesehen, der eine Höhe H aufweist. Der Rahmen 150 ragt auf der dem Objektiv 100 abgewandte Seiten der Trägerplatte 20 über die Oberfläche der Trägerplatte 20 hinaus. Bis auf die Höhe H des Rahmens 150 ist dieser mit einer Vergussmasse 210 angefüllt. Durch den Rahmen 150 in Verbindung mit der Vergussmasse 210 wird dem optischen Modul 1 eine große mechanische Stabilität verliehen. Diese Stabilität garantiert auch eine sichere, rüttelfeste Justierung des Objektivs 100 und damit eine hohe Betriebssicherheit des optischen Moduls 1. Dadurch kann der Wartungsaufwand für die Justierung der Optik 100 vermindert werden. Der Rahmen 150 und die Vergussmasse 210 garantieren nicht nur eine hohe mechanische Stabilität des optischen Moduls 1. Sie schützen auch die empfindlichen Komponenten des optischen Moduls 1, wie insbesondere den Bildsensor 10, vor schädlichen Umwelteinflüssen. So kann erfolgreich verhindert werden, dass Feuchtigkeit und Schmutz in das optische Modul 1 eindringen. Zugleich kann auch der Stecker 40 in die Vergussmasse 210 mit eingebettet werden, der dadurch mechanisch gut gesichert wird. In einer weiteren Variante kann, zur Einsparung von Kosten, auf den Stecker 40 verzichtet werden. In diesem Fall wird ein Endstück eines Anschlusskabels, nach Herstellung der elektrischen Verbindungen auf der Trägerplatte 20, mit der Vergussmasse 210 vergossen. Vorteilhaft kann dabei das optische Modul 1 auch noch gegen elektromagnetische Störungen abgeschirmt werden. Dazu werden elektrisch und magnetisch gut leitfähige Partikel 205, die beispielsweise aus einem ferromagnetischen Material bestehen, in die Vergussmasse 210 eingebettet. Dabei kann die Vergussmasse auch mehrschichtig aufgebracht werden. So können die Bauelemente des optischen Moduls 1 zunächst mit einer ersten Schicht der Vergussmasse 210, 220 abgedeckt werden, die noch keine Abschirmmittel enthält. Diese erste Schicht wird dann mit einer oder mehreren Lagen von Gussmasse abgedeckt, in denen Abschirmmittel vorgesehen sind. Alternativ oder zusätzlich zu den eingebetteten Partikeln kann ein feinmaschiges Gitter 180 oder Netz zu Abschirmungszwecken in die Vergussmasse 210 eingebracht werden. Dieses Gitter 180 oder Netz besteht aus einem elektrisch leitfähigen Material, beispielsweise aus Metall.

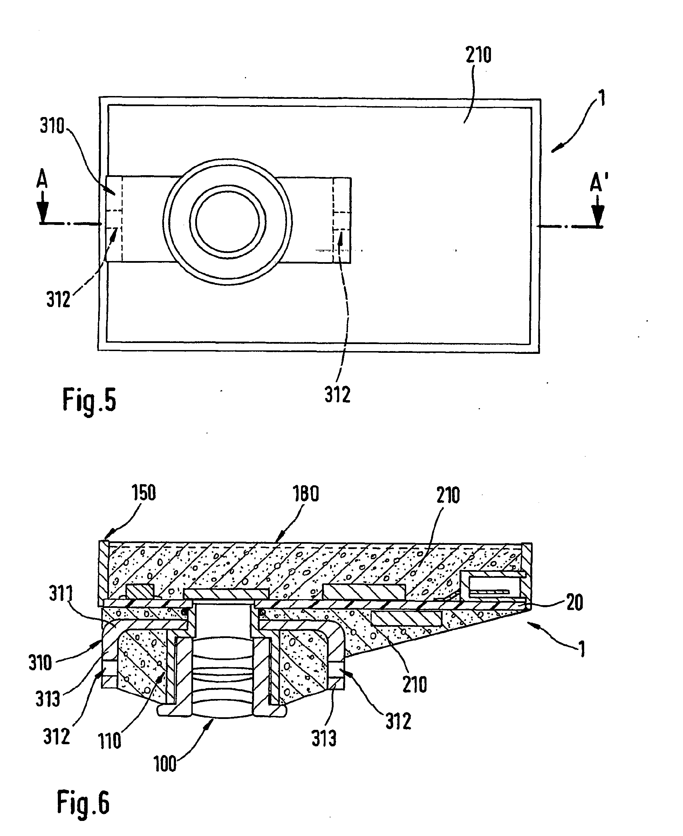

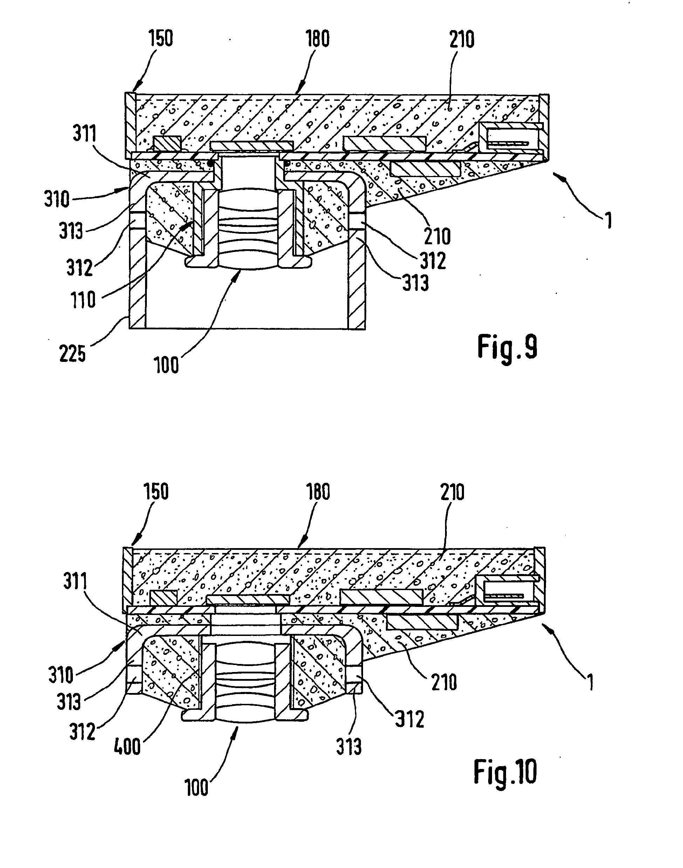

Figur 5 und Figur 6 verdeutlichen einen nächsten Verfahrensschritt für die Herstellung des optischen Moduls 1. Dabei zeigt Figur 5 eine Aufsicht auf die Vorderseite eines optischen Moduls 1, während Figur 6 einen Schnitt entlang der Linie A-A' von Figur 5 darstellt. Die Figuren zeigen, dass jetzt auch die Vorderseite des optischen Moduls 1, zusammen mit der Hülse 110 und der darin angeordneten Optik 100 in die Vergussmasse210 eingebettet sind. Dadurch wird die Stabilität des optischen Moduls 1 zusätzlich erhöht und es ergeben sich in verstärktem Maß die oben schon genannten Vorteile. Weiterhin ist in die Vergussmasse 210 ein Halteelement 310 eingegossen und dadurch fest mit dem optischen Modul 1 verbunden. Mit diesem Halteelement 310 kann das optische Modul 1 sicher an seinem Montageort, beispielsweise in einem Kraftfahrzeug, befestigt werden. In dem in den Figuren 5 und 6 dargestellten Ausführungsbeispiel besteht das Halteelement 310 aus zwei Winkeln, die mit jeweils einem ihrer Schenkel 311 die Hülse 110 an einem stufenförmigen Absatz der Hülse umgreifen. Jeweils der zweite Schenkel 313 der Winkel des Halteelements 310 erstreckt sich senkrecht von der Trägerplatte 20 des optischen Moduls 1 weg. Zweckmäßig ist in jedem Schenkel 313 der Winkel des Halteelements 310 eine Gewindebohrung 312 angeordnet. An seinem Montageort wird das optische Modul 1 dann auf einfache Weise durch Schrauben fixiert, die in diese Gewindebohrungen 312 eingreifen und das optische Modul 1 an einem Teil des hier nicht dargestellten Fahrzeugs fixieren. Geeignet sind weiterhin auch anders gestaltete Halteelemente. So kann in einem Ausführungsbeispiel der Erfindung ein im Wesentlichen topfförmig ausgestaltetes Halteelement vorgesehen sein, das die Optik 100 konzentrisch (Figur 9) umgibt. Eine Öffnung in dem Boden des Halteelements 310 ermöglicht dann den Lichtdurchtritt von der Optik 100 auf den Bildsensor 10. Auch ein so ausgestaltetes Halteelement 310 wird zweckmäßig in die Vergussmasse 210, 220 eingegossen. In einem weiteren vorteilhaften Ausführungsbeispiel der Erfindung kann eine Streulichtblende 225 vorgesehen sein, die die Optik 100 gegen Streulicht abschirmt. Auch diese Streulichtblende 225 kann an das optische Modul 1 angegossen oder mittels der Vergussmasse 210, 220 in das optische Modul 1 eingegossen sein. Bei Verwendung eines topfförmigen Halteelements 310 kann die Höhe des Topfmantels derart groß gewählt werden, dass das Halteelement 310 die Optik 100 gegen Streulicht abschirmt und auf diese Weise als Streulichtblende 225 wirkt (Figur 9).

Die Einbettung des optischen Moduls 1 in eine Vergussmasse 210,220 sorgt bereits für eine hermetisch dichte Umhüllung der empfindlichen optischen und elektronischen Komponenten, die in dem optischen Modul 1 verbaut sind. Dadurch kann langfristig verhindert werden, dass insbesondere Feuchtigkeit in das Innere des optischen Moduls 1 eindringt. Unter den widrigen Umweltbedingungen bei einem Einsatz in Kraftfahrzeugen kann dennoch nicht mit völliger Sicherheit ausgeschlossen werden, dass Feuchtigkeit in das optische Modul 1 eindringt und dass sich Kondenswasser bildet, das die Funktion des Bildsensors 10 und de Optik 100 beeinträchtigt.

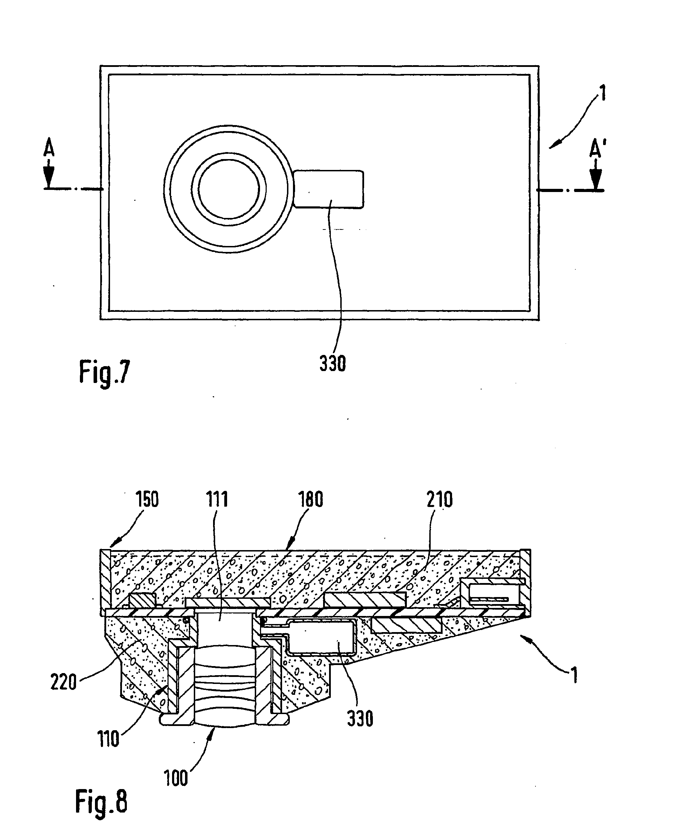

Um diese Situation zu verbessern, kann, wie anhand eines Beispiels (Figur 7, Figur 8) gezeigt wird, in dem optischen Modul 1 ein Vorratsbehälter für die Aufnahme eines Trocknungsmittels vorgesehen werden. Figur 7 zeigt eine Aufsicht auf ein weiteres optisches Modul 1, Figur 8 einen Schnitt entlang der Linie A-A' von Figur 7.

Der Vorratsbehälter ist mit Bezugsziffer 330 bezeichnet. Eine Öffnung des Vorratsbehälters steht mit dem Raum 111 zwischen dem Bildsensor 10 und der Optik 100 in Verbindung. Ein in dem Vorratsbehälter 330 vorhandenes Trocknungsmittel kann die sich in dem Raum 111 ansammelnde Feuchtigkeit binden. Als Trocknungsmittel eignet sich beispielsweise Silikagel oder ein Zeolitmaterial.

In einer weiteren, noch kostengünstigen Ausführungsvariante eines optischen Moduls 1 kann die Steckhülse 110 entfallen, weil die Optik 100, nach entsprechender Justierung über dem Bildsensor 10 direkt mit einer Baugruppe des optischen Moduls 1, insbesondere mit der Trägerplatte 20, verklebt und später mit der Vergussmasse 210 vergossen wird. Diese Variante eignet sich besonders für ein Fixfokusobjektiv, das später nicht mehr justiert werden muss.

In einer weiteren kostengünstigen Ausführungsvariante eines optischen Moduls 1 ist die Optik 100 justierbar in einem in die Vergussmasse 210, 220 eingegossenen Gewinde 400 (Figur 10) gelagert. Dieses Gewinde 400 kann kostengünstig dadurch hergestellt werden, dass bei dem Vergießen mit der Vergussmasse 210, 220 ein mit einem Außengewinde versehener Gewindestopfen in den Strahlengang vor dem Bildsensor 10 angeordnet und nach dem Aushärten der Vergussmasse 210,220 wieder entfernt wird. In das so entstandene Gewinde 400 ist eine mit einem Außengewinde ausgestattete Optik 100 einschraubbar. Auch hierdurch lässt sich eine Hülse 110 für die Aufnahme der Optik 100 einsparen.

## Patentansprüche

1. Optisches Modul (1) mit einem aus optischen und elektronischen Komponenten bestehenden Bildaufnehmer, wobei die Komponenten des Bildaufnehmers gemeinsam auf einer Trägerplatte (20) angeordnet sind, wobei die Komponenten des Bildaufnehmers auf einer ersten Hauptfläche der Trägerplatte (20) angeordnet sind und wobei eine dem Bildaufnehmer zugeordnete Optik (100) auf einer zweiten Hauptfläche der Trägerplatte (20) angeordnet ist, und wobei weiterhin die Trägerplatte (20) und die Optik (100) in eine Vergussmasse (210, 220) eingebettet sind, **dadurch gekennzeichnet, dass** das optische Modul (1) ein Halteelement (310) für die Befestigung des optischen Moduls (1) an einem Fahrzeugteil oder dergleichen umfasst, wobei das Halteelement (310) mit dem optischen Modul (1) vergossen ist.

2. Optisches Modul (1) nach Anspruch 1, **dadurch gekennzeichnet, dass** das Halteelement (310) aus zwei Winkeln besteht, die mit jeweils einem ihrer Schenkel (311) eine für die Aufnahme einer Optik (100) vorgesehene Hülse (110) an einem stufenförmigen Absatz der Hülse (110) umgreifen und deren jeweils zweiter Schenkel (313) sich senkrecht von der Trägerplatte (20) des optischen Moduls (1) weg erstreckt.

3. Optisches Modul (1) nach Anspruch 2, **dadurch gekennzeichnet, dass** in jedem Schenkel (313) des Halteelements (310) eine Gewindebohrung (312) angeordnet ist.

4. Optisches Modul (1) nach Anspruch 1, **dadurch gekennzeichnet, dass** das Halteelement (310) als Streulichtblende ausgebildet ist.

5. Optisches Modul (1) nach Anspruch 4, **dadurch gekennzeichnet, dass** das Halteelement (310) topfförmig ausgebildet ist.

## Claims

1. Optical module (1) having an image recording device consisting of optical and electronic components, the components of the image recording device being arranged jointly on a support plate (20), the components of the image recording device being arranged on a first main surface of the support plate (20), and an optics (100) assigned to the image recording device being arranged on a second main surface of the support plate (20) and, furthermore, the support plate (20) and the optics (100) being embedded in a potting compound (210, 220), **characterized in that** the optical module (1) comprises a holding element (310) for fastening the optical module (1) on a vehicle part or the like, the holding element (310) being potted with the optical module (1).

2. Optical module (1) according to Claim 1, **characterized in that** the holding element (310) consists of two angles which, with in each case one of the limbs (311) thereof, grip a sleeve (110), provided for accommodating an optics (100), on a stepped shoulder of the sleeve (110), and whose respective second limb (313) extends away perpendicularly from the support plate (20) of the optical module (1).

3. Optical module (1) according to Claim 2, **characterized in that** a threaded bore (312) is arranged in each limb (313) of the holding element (310).

4. Optical module (1) according to Claim 1, **characterized in that** the holding element (310) is designed as a baffle plate.

5. Optical module (1) according to Claim 4, **characterized in that** the holding element (310) is of pot-shaped design.

## Revendications

1. Module optique (1) présentant un enregistreur d'image constitué de composants optiques et de composants électroniques, les composants de l'enregistreur d'image étant disposés conjointement sur une plaque de support (20), les composants de l'enregistreur d'image étant disposés sur une première surface principale de la plaque de support (20) et une optique (100) associée à l'enregistreur d'image étant disposée sur une deuxième surface principale de la plaque de support (20), la plaque de support (20) et l'optique (100) étant en outre encapsulées dans une pâte de scellement (210, 220),
**caractérisé en ce que**
le module optique (1) comporte un élément de maintien (310) qui permet de fixer le module optique (1) sur une pièce de véhicule ou similaire, l'élément de maintien (310) étant encapsulé conjointement avec le module optique (1).

2. Module optique (1) selon la revendication 1, **caractérisé en ce que** l'élément de maintien (310) est constitué de deux cornières qui chevauchent chacune par une de leurs ailes (311) une douille (110) prévue sur un appendice en gradin de la douille (110) pour loger une optique (100) et dont la deuxième aile (313) s'éloigne perpendiculairement de la plaque de support (20) du module optique (1).

3. Module optique (1) selon la revendication 2, **caractérisé en ce qu'**un alésage fileté (312) est ménagé dans chaque aile (313) de l'élément de maintien (310).

4. Module optique (1) selon la revendication 1, **caractérisé en ce que** l'élément de maintien (310) est configuré comme écran contre la lumière diffuse.

5. Module optique (1) selon la revendication 4, **caractérisé en ce que** l'élément de maintien (310) est configuré en chapeau.
